# EUROPEAN PATENT SPECIFICATION

(11) **EP 2 469 609 B1**
(45) Date of publication and mention of the grant of the patent: **05.06.2013**
(21) Application number: 11002981.6
(22) Date of filing: 08.04.2011
(51) Int. Cl.: H01L 31/075, H01L 31/076

(54) **Thin film solar cell**
Dünnfilm-Solarzelle
Cellule solaire à couche mince

(30) Priority: 21.12.2010 KR 20100131821
(43) Date of publication of application: 27.06.2012
(73) Proprietor: LG Electronics Inc., Seoul 150-721 (KR)
(72) Inventor: Hwang, Suntae, Seoul 137-724 (KR); Lee, Seungyoon, Seoul 137-724 (KR); Chung, Jinwon, Seoul 137-724 (KR); Ahn, Sehwon, Seoul 137-724 (KR)
(74) Representative: Katérle, Axel

(56) References cited:
- US-A- 5 676 765
- US-A1- 2007 209 699
- US-A1- 2009 293 936
- US-A1- 2010 224 243
- US-A1- 2010 275 996
- US-B1- 6 951 689
- NIRUT PINGATE ET AL: "Microcrystalline SiO and its Application to Solar Cell", CONFERENCE RECORD OF THE 2006 IEEE 4TH WORLD CONFERENCE ON PHOTOVOLTAIC ENERGY CONVERSION (IEEE CAT. NO.06CH37747),, 1 May 2006 (2006-05-01), pages 1507-1508, XP031007605, ISBN: 978-1-4244-0016-4

## Description

### BACKGROUND OF THE INVENTION

### Field of the Invention

Embodiments of the invention relate to a thin film solar cell capable of using a back reflection layer as a doped layer.

### Description of the Related Art

Solar cells use an essentially infinite energy source, i.e., the sun, scarcely produce pollution materials in an electricity generation process, and has a very long life span equal to or longer than 20 years. Furthermore, the solar cells have been particularly spotlighted because of a large economic ripple effect on solar related industries. Thus, many countries have fostered the solar cells as a next generation industry.

Most of the solar cells have been manufactured based on a single crystal silicon wafer or a polycrystalline silicon wafer. In addition, thin film solar cells using silicon have been manufactured and sold in a smaller scale.

The solar cells have the problem of the high electricity generation cost compared to other energy sources. Thus, the electricity generation cost of the solar cells has to be greatly reduced so as to better meet a future demand for clean energy.

However, because a bulk solar cell manufactured based on the single crystal silicon wafer or the polycrystalline silicon wafer now uses a raw material having a thickness of at least 150 µm, the raw material cost, i.e., the silicon cost occupies most of the production cost of the bulk solar cell. Further, because the supply of the raw material does not meet the rapidly increasing demand, it is difficult to reduce the production cost of the bulk solar cell.

On the other hand, because a thickness of the thin film solar cell is less than 2 µm, an amount of raw material used in the thin film solar cell is much less than an amount of raw material used in the bulk solar cell. Thus, the thin film solar cell is more advantageous than the bulk solar cell in terms of the electricity generation cost, i.e., the production cost. However, an electricity generation performance of the thin film solar cell is one half of an electricity generation performance of the bulk solar cell having the same surface area.

The efficiency of the solar cell is generally expressed by a magnitude of a power obtained at a light intensity of 100 mW/cm² in terms of percentage. The efficiency of the bulk solar cell is about 12 % to 20 %, and the efficiency of the thin film solar cell is about 8 % to 9 %. In other words, the efficiency of the bulk solar cell is greater than the efficiency of the thin film solar cell.

The most basic structure of the thin film solar cell is a single junction structure. The single junction thin film solar cell is configured so that a photoelectric conversion unit including an intrinsic layer for light absorption, a p-type doped layer, and an n-type doped layer is formed on a substrate. The p-type doped layer and the n-type doped layer are respectively formed on and under the intrinsic layer, thereby forming an inner electric field for separating carriers produced by solar light.

The efficiency of the single junction thin film solar cell including one photoelectric conversion unit is not high. Thus, a double junction thin film solar cell including two photoelectric conversion units and a triple junction thin film solar cell including three photoelectric conversion units have been developed, so as to increase the efficiency of the thin film solar cell.

Each of the double junction thin film solar cell and the triple junction thin film solar cell is configured so that a first photoelectric conversion unit first absorbing solar light is formed of a semiconductor material (for example, amorphous silicon) having a wide band gap to absorb solar light of a short wavelength band, and a second photoelectric conversion unit later absorbing the solar light is formed of a semiconductor material (for example, microcrystalline silicon) having a narrow band gap to absorb solar light of a long wavelength band. Hence, the efficiency of each of the double junction thin film solar cell and the triple junction thin film solar cell is greater than the efficiency of the single junction thin film solar cell.

The increase in the efficiency of the thin film solar cell requires an increase in a density of current flowing in the thin film solar cell. Thus, the thin film solar cell is configured so that solar light passing through the intrinsic layer is reflected to the intrinsic layer and then is absorbed in the intrinsic layer. As a result, the thin film solar cell includes a back reflection layer for increasing the light absorptance of the intrinsic layer, thereby increasing the current density.

The preamble of claim 1 is known from document US 2007/0209699.

### SUMMARY OF THE INVENTION

The present invention is defined by a thin film solar cell according to claim 1.

The first back reflection layer may be formed of a material that has an absorption coefficient equal to or less than about 400 cm-1 with respect to a solar light component having a wavelength equal to or greater than about 700 nm. The first back reflection layer may be formed of a material that has a refractive index of about 1.5 to 2.5 at a wavelength of about 800 nm.

The first intrinsic layer may be formed of a material that has a refractive index of about 3 to 5 at a wavelength of about 800 nm. The first intrinsic layer may contain one of hydrogenated amorphous silicon (a-Si:H) and hydrogenated microcrystalline silicon (µc-Si:H).

The first back reflection layer is formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H).

The back reflection layer further includes a second back reflection layer formed of a material that has an absorption coefficient equal to or greater than about 400 cm-1 with respect to a solar light component having a wavelength equal to or greater than about 700 nm. An electrical conductivity of the second back reflection layer may be greater than an electrical conductivity of the first back reflection layer. The second back reflection layer is formed of one of aluminum-doped zinc oxide (AZO) and boron-doped zinc oxide (BZO). The second back reflection layer may be positioned at a back surface of the first back reflection layer.

The thin film solar cell may further include a second photoelectric conversion unit between the first photoelectric conversion unit and the substrate, and the second photoelectric conversion unit may include a second intrinsic layer.

The thin film solar cell may further include a middle reflection layer between the first photoelectric conversion unit and the second photoelectric conversion unit. The middle reflection layer may include a first middle reflection layer directly contacting the first intrinsic layer. The first middle reflection layer may be formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H).

In this instance, the middle reflection layer may further include a second middle reflection layer directly contacting both the first middle reflection layer and the second intrinsic layer. The second middle reflection layer may be formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H).

Alternatively, the middle reflection layer may include a first middle reflection layer directly contacting a p-type doped layer of the first photoelectric conversion unit. The first middle reflection layer may be formed of one of aluminum-doped zinc oxide (AZO) and boron-doped zinc oxide (BZO).

In this instance, the middle reflection layer may further include a second middle reflection layer directly contacting both the first middle reflection layer and the second intrinsic layer. The second middle reflection layer may be formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H).

The thin film solar cell may further include a third photoelectric conversion unit between the second photoelectric conversion unit and the substrate.

The thin film solar cell may further include at least one middle reflection layer between the first and third photoelectric conversion units.

The at least one middle reflection layer may include a first middle reflection layer that is formed of one of aluminum-doped zinc oxide (AZO) and boron-doped zinc oxide (BZO), or is formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H).

The at least one middle reflection layer may further include a second middle reflection layer that is formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H).

In general, light, that is transmitted by the first intrinsic layer and then is reflected from the back reflection layer, passes through a doped layer (for example, an n-type doped layer in a superstrate structure in which the light is incident through the substrate) contacting the back reflection layer two times. Therefore, a portion of the light is absorbed in the n-type doped layer. As a result, a loss of light is generated.

In the embodiment of the invention using the first back reflection layer of the back reflection layer as a doped layer, the first back reflection layer directly contacts the first intrinsic layer. Therefore, the loss of light is reduced or prevented. As a result, a current reduction of the thin film solar cell is reduced or prevented.

In the embodiment of the invention, because the first back reflection layer is formed of one of hydrogenated microcrystalline silicon oxide (µc-SiOx:H), hydrogenated microcrystalline silicon nitride (µc-SiNx:H), and hydrogenated microcrystalline silicon oxynitride (µc-SiOxNy:H), a solar light component having a long wavelength reaching the second photoelectric conversion unit or the third photoelectric conversion unit is efficiently reflected. Hence, a current of the second and third photoelectric conversion units may increase.

When the back reflection layer has a double-layered structure including the first back reflection layer formed of hydrogenated microcrystalline silicon oxide (µc-SiOx:H) and the second back reflection layer formed of doped zinc oxide, a thickness of the first back reflection layer in the back reflection layer having the double-layered structure may be less than a thickness of a first back reflection layer in a back reflection layer having a single-layered structure including only the first back reflection layer. Thus, process time and the manufacturing cost required to deposit the first back reflection layer may decrease.

Furthermore, current flowing in each of the photoelectric conversion units may be balanced by optimizing a thickness of each of the middle reflection layer and the back reflection layer. Hence, the efficiency of the thin film solar cell may be improved.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:

FIG. 1 is a partial cross-sectional view schematically illustrating a single junction thin film solar cell according to a first example embodiment ot part of the invention;

FIG. 2 is a graph illustrating a light absorption coefficient depending on a formation material of a first reflection layer;

FIG. 3 is a graph illustrating efficiency of the single junction thin film solar cell shown in FIG. 1 and efficiency of a related art thin film solar cell;

FIG. 4 is a table numerically expressing the graph of FIG. 3;

FIG. 5 is a partial cross-sectional view illustrating a modified embodiment of the single junction thin film solar cell shown in FIG. 1;

FIG. 6 is a partial cross-sectional view schematically illustrating a double junction thin film solar cell according to a second example embodiment of the invention;

FIG. 7 is a partial cross-sectional view illustrating a modified embodiment of the double junction thin film solar cell shown in FIG. 6;

FIG. 8 is a partial cross-sectional view illustrating another modified embodiment of the double junction thin film solar cell shown in FIG. 6; and

FIG. 9 is a partial cross-sectional view schematically illustrating a triple junction thin film solar cell according to a third example embodiment of the invention.

### DETAILED DESCRIPTION OF THE EMBODIMENTS

Embodiments of the invention will be described more fully hereinafter with reference to the accompanying drawings, in which example embodiments of the invention are shown. This invention may, however, be embodied in many different forms and should not be construed as limited to the embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on another element, it may be on the entire surface of the other element and may not be on a portion of an edge of the other element.

Reference will now be made in detail to embodiments of the invention, examples of which are illustrated in the accompanying drawings.

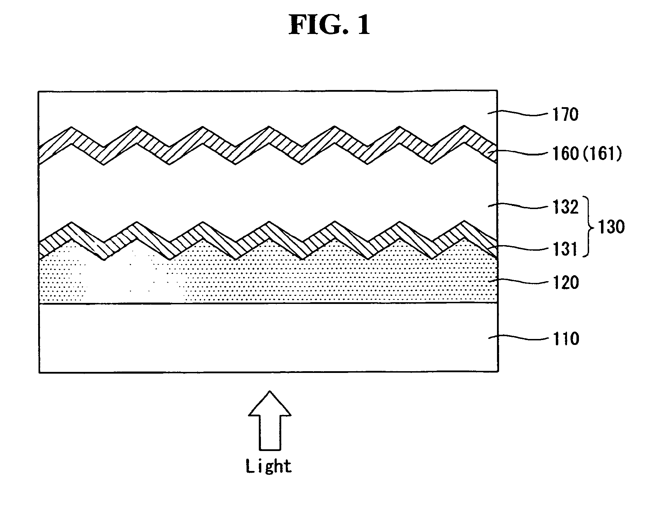

FIG. 1 schematically illustrates a thin film solar cell according to a first example embodiment not part of the invention. More specifically, FIG. 1 is a partial cross-sectional view of a single junction thin film solar cell according to the first example embodiment not part of the invention.

As shown in FIG. 1, a single junction thin film solar cell according to the first example embodiment not part of the invention has a superstrate structure in which light is incident through a substrate 110. However, the single junction thin film solar cell according to the first example embodiment of the invention may also have a substrate structure in which light is not incident through the substrate, or light is incident from an opposite side of the single junction thin film solar cell from the substrate.

The single junction thin film solar cell having the superstrate structure includes a substrate 110 formed of, for example, glass or transparent plastic, etc., an electrode 120 such as a transparent conductive oxide (TCO) electrode 120 positioned on the substrate 110, a first photoelectric conversion unit 130 positioned on the TCO electrode 120, a back reflection layer 160 positioned on the first photoelectric conversion unit 130, and a back electrode 170 positioned on the back reflection layer 160. In the embodiment of the invention, the TCO electrode 120 may be referred to as a first electrode, and the back electrode 170 may be referred to as a second electrode.

The TCO electrode 120 is formed on the entire surface of the substrate 110 and is electrically connected to the first photoelectric conversion unit 130. Thus, the TCO electrode 120 collects carriers (for example, holes) produced by light and outputs the carriers. Further, the TCO electrode 120 may serve as an anti-reflection layer.

An upper surface of the TCO electrode 120 may be textured to form a textured surface having a plurality of uneven portions having, for example, a non-uniform pyramid shape. When the upper surface of the TCO electrode 120 is the textured surface, a light reflectance of the TCO electrode 120 is reduced. Hence, a light absorptance of the TCO electrode 120 increases, and efficiency of the single junction thin film solar cell is improved. Heights of the uneven portions of the TCO electrode 120 may be within the range of about 1 µm to 10 µm.

A high transmittance and high electrical conductivity are required in the TCO electrode 120, so that the TCO electrode 120 can transmit most of incident light and electric current smoothly flows in the TCO electrode 120. The TCO electrode 120 may be formed of at least one selected from the group consisting of indium tin oxide (ITO), tin-based oxide (for example, SnO₂) AgO, ZnO-(Ga₂O₃ or Al₂O₃), fluorine tin oxide (FTO), and a combination thereof. A specific resistance of the TCO electrode 120 may be approximately 10⁻² Ω·cm to 10⁻¹¹ Ω·cm.

The first photoelectric conversion unit 130 may be formed of hydrogenated amorphous silicon (a-Si:H), microcrystalline silicon (µc-Si) or hydrogenated microcrystalline silicon (µc-Si:H). The first photoelectric conversion unit 130 includes a semiconductor layer 131 of a first conductive type (for example, a first p-type doped layer 131) and a first intrinsic layer 132, that are sequentially stacked on the TCO electrode 120.

The first p-type doped layer 131 may be formed by mixing a gas containing impurities of a group III element such as boron (B), gallium (Ga), and indium (In) with a raw gas containing silicon (Si). In the embodiment of the invention, the first p-type doped layer 131 may be formed of a material having a refractive index of about 3 to 5 at a wavelength of about 800 nm, for example, hydrogenated amorphous silicon (a-Si:H), microcrystalline silicon (µc-Si) or hydrogenated microcrystalline silicon (µc-Si:H). An element such as carbon (C) or oxygen (O) of several percentages to several tens of percentages may be added to the first p-type doped layer 131 so as to adjust a band gap of the first p-type doped layer 131.

The first intrinsic layer 132 prevents or reduces a recombination of carriers and absorbs light. The carriers (i.e., electrons and holes) are mostly produced in the first intrinsic layer 132. The first intrinsic layer 132 may be formed of a material having a refractive index of about 3 to 5 at a wavelength of about 800 nm, for example, hydrogenated amorphous silicon (a-Si:H), microcrystalline silicon (µc-Si) or hydrogenated microcrystalline silicon (µc-Si:H). An element such as carbon (C), oxygen (O), or germanium (Ge) of several percentages to several tens of percentages may be added to the first intrinsic layer 132 so as to adjust a band gap of the first intrinsic layer 132.

The back reflection layer 160 directly contacting the first intrinsic layer 132 reflects light passing through, or transmitted by, the first intrinsic layer 132 to the first intrinsic layer 132, thereby improving an operation efficiency of the first photoelectric conversion unit 130. The back reflection layer 160 includes a first back reflection layer 161. Accordingly, any light that is passing through, or transmitted by, the first intrinsic layer 132 is light that is not absorbed in the first intrinsic layer 132. An amount of light reflected back to the first intrinsic layer 132 may be some or all of an amount of light that passes through the first intrinsic layer.

In the related art, the back reflection layer was formed of doped zinc oxide, for example, aluminum-doped zinc oxide (AZO) or boron-doped zinc oxide (BZO). The doped zinc oxide has a high absorptance with respect to a solar light component having a wavelength equal to or greater than about 700 nm. More specifically, the doped zinc oxide has the absorptance equal to or greater than about 400 cm⁻¹ with respect to the solar light component having the wavelength equal to or greater than about 700 nm. Thus, most of long-wavelength light reaching the back reflection layer is absorbed in the back reflection layer. As a result, a loss of light increases.

To prevent or reduce the absorption of the long-wavelength light in the back reflection layer, in the embodiment of the invention, the first back reflection layer 161 included in the back reflection layer 160 is formed of a material that has an absorption coefficient equal to or less than about 400 cm⁻¹ with respect to the solar light component having the wavelength equal to or greater than about 700 nm and has a refractive index of about 1.5 to 2.5 at a wavelength of about 800 nm. Examples of material satisfying the above-described conditions of the absorption coefficient and the refractive index include hydrogenated microcrystalline silicon oxide (µc-SiOx:H), hydrogenated microcrystalline silicon nitride (µc-SiNx:H), and hydrogenated microcrystalline silicon oxynitride (µc-SiOxNy:H).

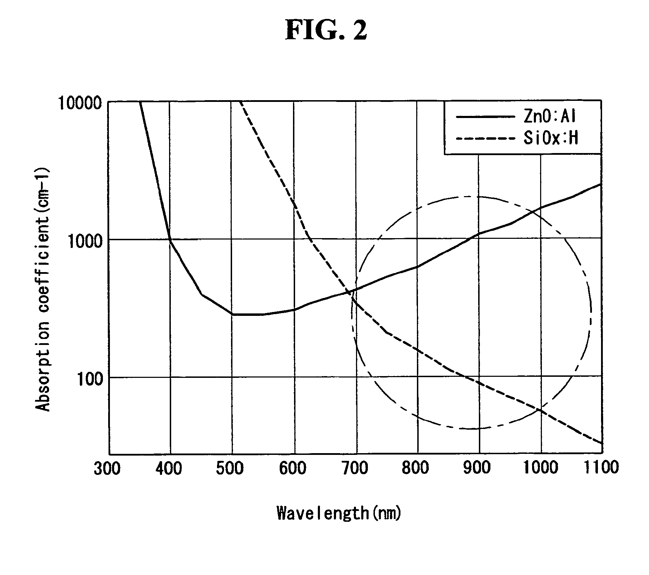

As shown in FIG. 2, hydrogenated microcrystalline silicon oxide (µc-SiOx:H) has a very small absorption coefficient with respect to the solar light component having the wavelength equal to or greater than about 700 nm, compared to the doped zinc oxide. Thus, the back reflection layer 160 including the first back reflection layer 161 formed of µc-SiOx:H does not absorb most of the long-wavelength light reaching the back reflection layer 160 and transmits or reflects most of the long-wavelength light reaching the back reflection layer 160. As a result, a loss of light may be minimized.

The first back reflection layer 161 formed of hydrogenated microcrystalline silicon oxide has conductivity less than the back reflection layer formed of the doped zinc oxide. However, the conductivity of the first back reflection layer 161 may be properly controlled by controlling an injection amount of oxygen in the formation of the first back reflection layer 161. Hence, the problem resulting from a reduction in the conductivity of the first back reflection layer 161 may be reduced or prevented. A thickness of the first back reflection layer 161 may be properly set to several tens of nanometers (nm) to several micrometers (µm).

FIG. 2 illustrates the first back reflection layer 161 formed of hydrogenated microcrystalline silicon oxide. However, the first back reflection layer 161 may be formed of hydrogenated microcrystalline silicon nitride (µc-SiNx:H) or hydrogenated microcrystalline silicon oxynitride (µc-SiOxNy:H), for example.

In the embodiment of the invention, the first back reflection layer 161 serves as an n-type doped layer of the first photoelectric conversion unit 130. For this, the first back reflection layer 161 may be formed by mixing a gas containing impurities of a group V element such as phosphorus (P), arsenic (As), and antimony (Sb) with a raw gas containing silicon (Si).

The first photoelectric conversion unit 130 and the first back reflection layer 161 may be formed using a chemical vapor deposition (CVD) method such as a plasma enhanced CVD (PECVD) method.

The first p-type doped layer 131 of the first photoelectric conversion unit 130 and the first back reflection layer 161 of the back reflection layer 160 form a p-n junction with the first intrinsic layer 132 interposed therebetween. Hence, electrons and holes produced in the first intrinsic layer 132 are separated by a contact potential difference and move in different directions. For example, the holes move to the TCO electrode 120 through the first p-type doped layer 131, and the electrons move to the back electrode 170 through the first back reflection layer 161.

The back electrode 170 is formed on the entire surface of the back reflection layer 160 and is electrically connected to the back reflection layer 160. The back electrode 170 collects carriers (for example, electrons) produced by the p-n junction and outputs the carriers.

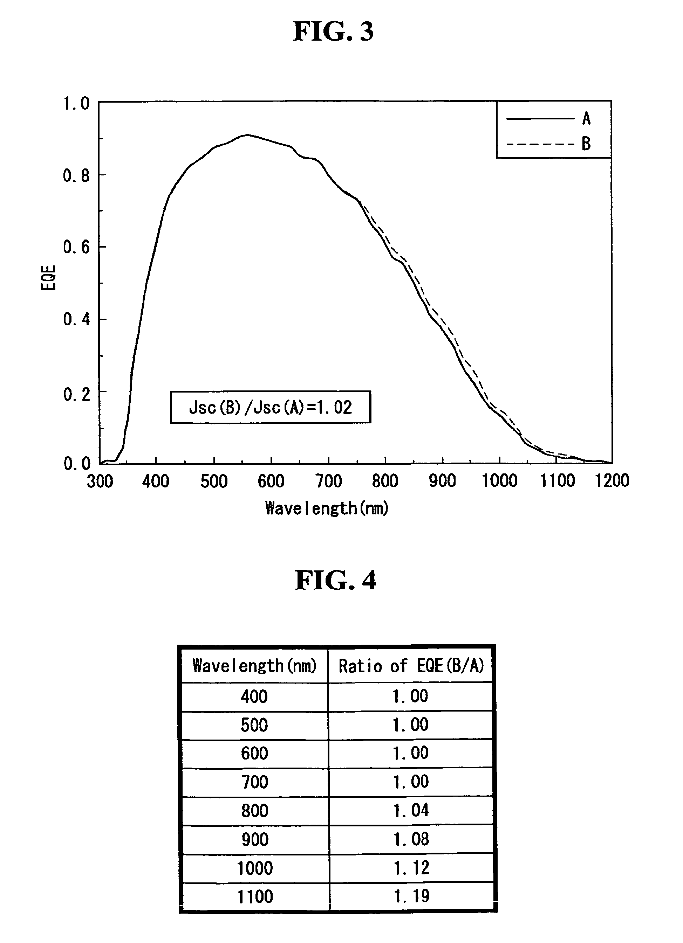

FIGS. 3 and 4 illustrate comparisons between an efficiency of the thin film solar cell according to the embodiment of the invention and an efficiency of the related art thin film solar cell. In the comparisons illustrated in FIGS. 3 and 4, the thin film solar cell according to the embodiment of the invention includes the first p-type doped layer 131 formed of hydrogenated microcrystalline silicon (µc-Si:H), the first intrinsic layer 132 formed of hydrogenated microcrystalline silicon (µc-Si:H), and the first back reflection layer 161 formed of n-type hydrogenated microcrystalline silicon oxide (µc-SiOx:H).

As shown in FIGS. 3 and 4, an efficiency EQE of the thin film solar cell "B" according to the embodiment of the invention was slightly greater than an efficiency EQE of the related art thin film solar cell "A" in an infrared band having the wavelength equal to or greater than 700 nm. In particular, as the wavelength increases, the efficiency EQE of the thin film solar cell "B" increased to about 20 %. Further, a current density Jsc of the thin film solar cell "B" according to the embodiment of the invention was greater than a current density Jsc of the related art thin film solar cell "A" by about 2%.

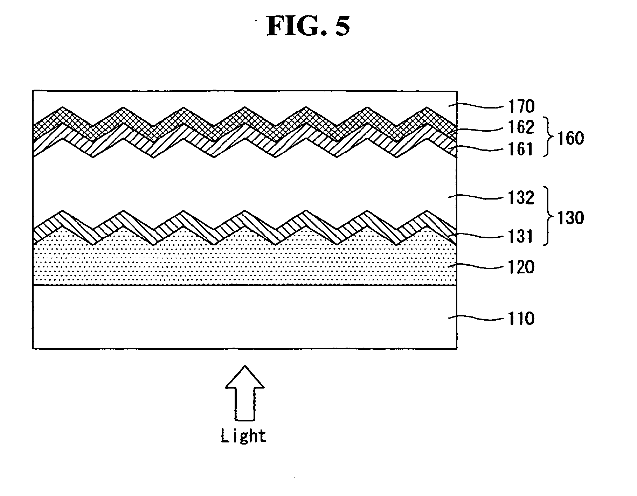

Hereinafter, a modified embodiment of the single junction thin film solar cell shown in FIG. 1 is described with reference to FIG. 5. In the first example embodiment illustrated in FIG. 1, process time and the manufacturing cost required to deposit the back reflection layer 160 including only the first reflection layer 161 may increase compared to the related art back reflection layer formed of the doped zinc oxide.

As shown in FIG. 5, in the modified embodiment of the invention, a back reflection layer 160 may further include a second back reflection layer 162 positioned at a back surface of a first back reflection layer 161 formed of hydrogenated microcrystalline silicon oxide (µc-SiOx:H).

The second back reflection layer 162 may be formed of a material that has electrical conductivity greater than the first back reflection layer 161 and has an absorptance equal to or greater than about 400 cm⁻¹ with respect to the solar light component having the wavelength equal to or greater than about 700 nm. For example, the second back reflection layer 162 may be formed of one of aluminum-doped zinc oxide (AZO) and boron-doped zinc oxide (BZO).

When the second back reflection layer 162 is formed at the back surface of the first back reflection layer 161 in the modified embodiment of the invention, the first back reflection layer 161 shown in FIG. 5 may be formed to be thinner than the first back reflection layer 161 shown in FIG. 1. Therefore, an increase in process time and the manufacturing cost required to form the back reflection layer 160 of FIG. 3 may be minimized.

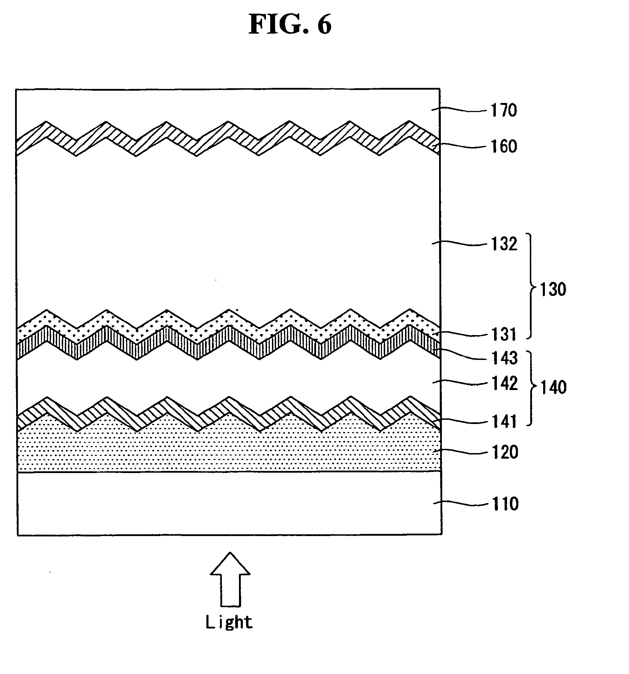

Hereinafter, a thin film solar cell according to a second example embodiment of the invention is described with reference to FIGS. 6 to 8. Structures and components identical or equivalent to those described in the first and second example embodiments are designated with the same reference numerals, and a further description may be briefly made or may be entirely omitted.

FIG. 6 schematically illustrates a thin film solar cell according to a second example embodiment of the invention. More specifically, FIG. 6 is a partial cross-sectional view of a double junction thin film solar cell according to the second example embodiment of the invention.

The double junction thin film solar cell according to the second example embodiment of the invention further includes a second photoelectric conversion unit 140 between a first photoelectric conversion unit 130 and a TCO electrode 120.

In the double junction thin film solar cell shown in FIG. 6, the second photoelectric conversion unit 140 may be formed of hydrogenated amorphous silicon (a-Si:H), and the first photoelectric conversion unit 130 may be formed of hydrogenated microcrystalline silicon (µc-Si:H). The second photoelectric conversion unit 140 formed of hydrogenated amorphous silicon has an optical band gap of about 1.7 eV and mostly absorbs light of a short wavelength band such as near ultraviolet rays, purple light, and blue light. The first photoelectric conversion unit 130 formed of hydrogenated microcrystalline silicon has an optical band gap of about 1.1 eV and mostly absorbs light of a long wavelength band from red light to near infrared light. Thus, the efficiency of the double junction thin film solar cell according to the second example embodiment of the invention is more excellent or improved than the efficiency of the single junction thin film solar cell according to the first example embodiment of the invention.

The second photoelectric conversion unit 140 includes a second p-type doped layer 141, a second intrinsic layer 142, and a second n-type doped layer 143, that are sequentially stacked on the TCO electrode 120. The second p-type doped layer 141 may be formed by mixing a gas containing impurities of a group III element such as boron (B), gallium (Ga), and indium (In) with a raw gas containing silicon (Si). The second n-type doped layer 143 may be formed by mixing a gas containing impurities of a group V element such as phosphorus (P), arsenic (As), and antimony (Sb) with a raw gas containing silicon (Si).

The first photoelectric conversion unit 130 includes a first p-type doped layer 131 and a first intrinsic layer 132, that are sequentially stacked on the second n-type doped layer 143 of the second photoelectric conversion unit 140.

A back reflection layer 160 having the same structure as the first example embodiment of the invention is formed on the first intrinsic layer 132. The back reflection layer 160 directly contacts the first intrinsic layer 132.

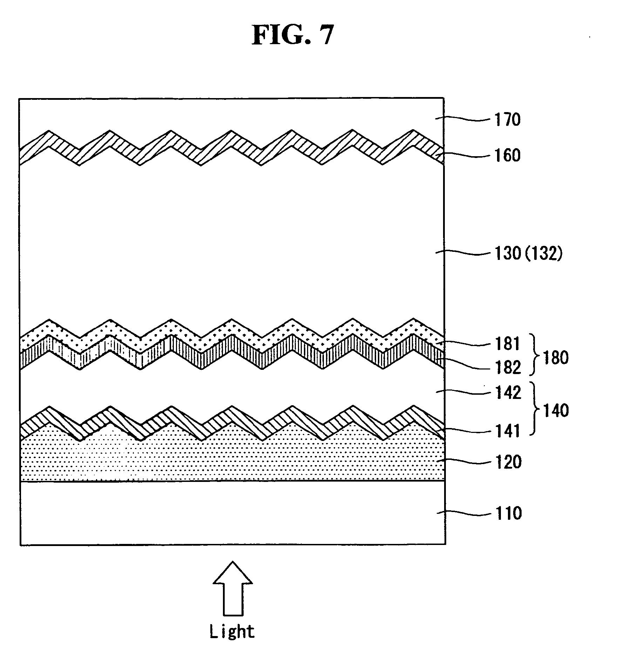

FIG. 7 illustrates a modified embodiment of the double junction thin film solar cell shown in FIG. 6. In the modified embodiment of the invention, a second photoelectric conversion unit 140 includes a second p-type doped layer 141 and a second intrinsic layer 142. A first photoelectric conversion unit 130 includes a first intrinsic layer 132. A middle reflection layer 180 is formed between the first intrinsic layer 132 and the second intrinsic layer 142.

The middle reflection layer 180 reflects a solar light component of a short wavelength band toward the second photoelectric conversion unit 140 and transmits a solar light component of a long wavelength band to the first photoelectric conversion unit 130.

The middle reflection layer 180 includes a first middle reflection layer 181 and a second middle reflection layer 182. The first middle reflection layer 181 may be formed of one of hydrogenated amorphous silicon (a-Si:H), microcrystalline silicon (µc-Si), and hydrogenated microcrystalline silicon (µc-Si:H). The second middle reflection layer 182 may be formed of the same material as the first middle reflection layer 181 or a material different from the first middle reflection layer 181 selected among hydrogenated amorphous silicon (a-Si:H), microcrystalline silicon (µc-Si), and hydrogenated microcrystalline silicon (µc-Si:H).

The second middle reflection layer 182 contacting the second intrinsic layer 142 and the first middle reflection layer 181 is doped with n-type impurities so as to serve as an n-type doped layer of the second photoelectric conversion unit 140. The first middle reflection layer 181 contacting the first intrinsic layer 132 and the second middle reflection layer 182 is doped with p-type impurities so as to serve as a p-type doped layer of the first photoelectric conversion unit 130.

Although FIG. 7 illustrates the middle reflection layer 180 having a double-layered structure including the first middle reflection layer 181 and the second middle reflection layer 182, the middle reflection layer 180 may have a single-layered structure in other embodiments.

In other words, the middle reflection layer 180 may have the single-layered structure including only one of the first middle reflection layer 181 and the second middle reflection layer 182. However, in this instance, the structure of the first photoelectric conversion unit 130 or the second photoelectric conversion unit 140 may vary depending on a conductive type of impurities with which the middle reflection layer 180 is doped.

More specifically, when the middle reflection layer 180 includes only the second middle reflection layer 182 doped with the n-type impurities, a first p-type doped layer of the first photoelectric conversion unit 130 may be positioned at a location corresponding to the first middle reflection layer 181. Further, when the middle reflection layer 180 includes only the first middle reflection layer 181 doped with the p-type impurities, a second n-type doped layer of the second photoelectric conversion unit 140 may be positioned at a location corresponding to the second middle reflection layer 182.

A back reflection layer 160 having the same structure as the first example embodiment of the invention is formed on the first intrinsic layer 132 of the first photoelectric conversion unit 130.

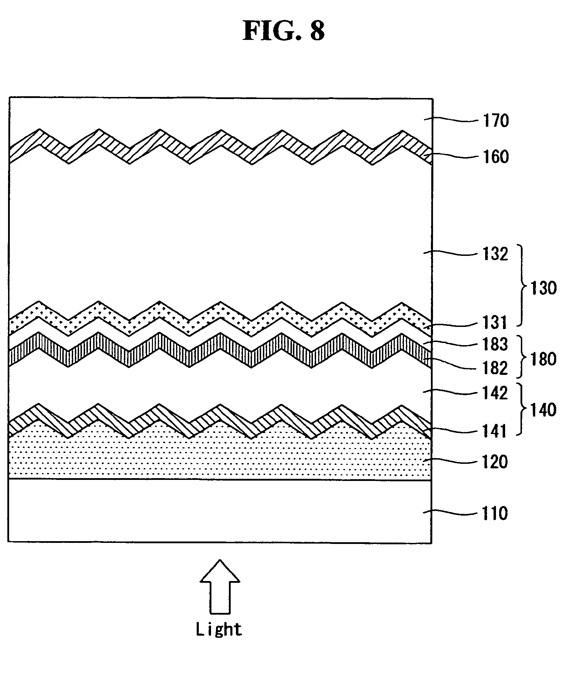

FIG. 8 illustrates another modified embodiment of the double junction thin film solar cell shown in FIG. 6. In this modified embodiment of the invention, a first photoelectric conversion unit 130 includes a first p-type doped layer 131 and a first intrinsic layer 132, and a second photoelectric conversion unit 140 includes a second p-type doped layer 141 and a second intrinsic layer 142.

A middle reflection layer 180 includes a first middle reflection layer 183 directly contacting the first p-type doped layer 131 of the first photoelectric conversion unit 130 and a second middle reflection layer 182 directly contacting the second intrinsic layer 142 and the first middle reflection layer 183.

The first middle reflection layer 183 may be formed of one of aluminum-doped zinc oxide (AZO) and boron-doped zinc oxide (BZO). The second middle reflection layer 182 may be formed of one of n-type hydrogenated microcrystalline silicon oxide (µc-SiOx:H), n-type hydrogenated microcrystalline silicon nitride (µc-SiNx:H), and n-type hydrogenated microcrystalline silicon oxynitride (µc-SiOxNy:H).

The middle reflection layer 180 may include only one of the first middle reflection layer 183 and the second middle reflection layer 182.

A back reflection layer 160 having the same structure as the first example embodiment of the invention is formed on the first intrinsic layer 132 of the first photoelectric conversion unit 130.

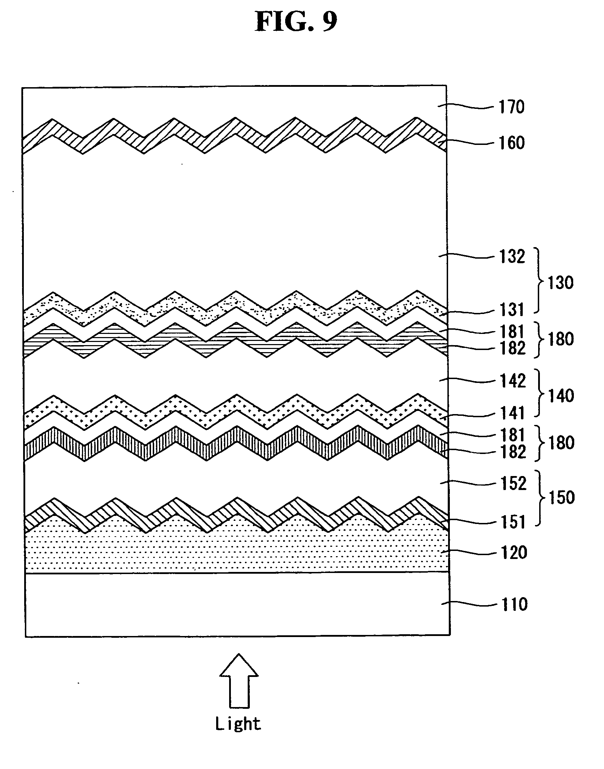

FIG. 9 schematically illustrates a thin film solar cell according to a third example embodiment of the invention. More specifically, FIG. 9 is a partial cross-sectional view of a triple junction thin film solar cell according to the third example embodiment of the invention.

The triple junction thin film solar cell according to the third example embodiment of the invention further includes a third photoelectric conversion unit 150 between a second photoelectric conversion unit 140 and a TCO electrode 120.

In the third example embodiment of the invention, a first photoelectric conversion unit 130 includes a first p-type doped layer 131 and a first intrinsic layer 132, a second photoelectric conversion unit 140 includes a second p-type doped layer 141 and a second intrinsic layer 142, and a third photoelectric conversion unit 150 includes a third p-type doped layer 151 and a third intrinsic layer 152.

Middle reflection layers 180 are formed between the first photoelectric conversion unit 130 and the second photoelectric conversion unit 140 and between the second photoelectric conversion unit 140 and the third photoelectric conversion unit 150, respectively.

As shown in FIG. 9, the middle reflection layer 180 between the first and second photoelectric conversion units 130 and 140 includes a first middle reflection layer 181 contacting the first p-type doped layer 131 and a second middle reflection layer 182 contacting the second intrinsic layer 142 and the first middle reflection layer 181. The middle reflection layer 180 between the second and third photoelectric conversion units 140 and 150 includes a first middle reflection layer 181 contacting the second p-type doped layer 141 and a second middle reflection layer 182 contacting the third intrinsic layer 152 and the first middle reflection layer 181.

The first middle reflection layer 181 may be formed of one of n-type hydrogenated microcrystalline silicon oxide (µc-SiOx:H), n-type hydrogenated microcrystalline silicon nitride (µc-SiNx:H), and n-type hydrogenated microcrystalline silicon oxynitride (µc-SiOxNy:H). Alternatively, the first middle reflection layer 181 may be formed of one of aluminum-doped zinc oxide (AZO) and boron-doped zinc oxide (BZO). The second middle reflection layer 182 may be formed of one of p-type hydrogenated microcrystalline silicon oxide (µc-SiOx:H), p-type hydrogenated microcrystalline silicon nitride (µc-SiNx:H), and p-type hydrogenated microcrystalline silicon oxynitride (µc-SiOxNy:H).

In the third example embodiment of the invention, the middle reflection layer 180 between the first and second photoelectric conversion units 130 and 140 and the middle reflection layer 180 between the second and third photoelectric conversion units 140 and 150 are formed of the same material and have the same layered structure. However, such is not required, and the middle reflection layer 180 between the first and second photoelectric conversion units 130 and 140 and the middle reflection layer 180 between the second and third photoelectric conversion units 140 and 150 may be formed of different materials or may have different layered structures.

For example, the middle reflection layer 180 between the first and second photoelectric conversion units 130 and 140 may have a double-layered structure including the first and second middle reflection layers, and the middle reflection layer 180 between the second and third photoelectric conversion units 140 and 150 may have a single-layered structure including only one of the first and second middle reflection layers, and vice versa.

Alternatively, the middle reflection layer 180 between the first and second photoelectric conversion units 130 and 140 and the middle reflection layer 180 between the second and third photoelectric conversion units 140 and 150 may have the single-layered structure. In this instance, the middle reflection layers 180 each having the single-layered structure may be formed of the same material or different materials.

For example, the middle reflection layer 180 between the first and second photoelectric conversion units 130 and 140 and the middle reflection layer 180 between the second and third photoelectric conversion units 140 and 150 may be formed of the same material or different materials selected among n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H).

Alternatively, the middle reflection layer 180 between the first and second photoelectric conversion units 130 and 140 and the middle reflection layer 180 between the second and third photoelectric conversion units 140 and 150 may be formed of the same material or different materials selected among aluminum-doped zinc oxide (AZO) and boron-doped zinc oxide (BZO).

Alternatively, the middle reflection layer 180 between the first and second photoelectric conversion units 130 and 140 may be formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H), and the middle reflection layer 180 between the second and third photoelectric conversion units 140 and 150 may be formed of one of aluminum-doped zinc oxide (AZO) and boron-doped zinc oxide (BZO), and vice versa.

The formation material of the two middle reflection layers 180 may depend on various factors such as a thickness and a refractive index of the photoelectric conversion unit.

A back reflection layer 160 having the same structure as the first example embodiment of the invention is formed on the first intrinsic layer 132 of the first photoelectric conversion unit 130.

In embodiments of the invention, reference to a front surface may refer to a light incident surface or a surface facing incident light from outside, and reference to a back surface may refer to an opposite surface to the front surface.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A thin film solar cell comprising:
a substrate (110);
a first photoelectric conversion unit (130) positioned on the substrate (110), the first photoelectric conversion unit (130) including a first intrinsic layer (132) for light absorption; and
a back reflection layer (160) configured to reflect light transmitted by the first photoelectric conversion unit (130) back to the first photoelectric conversion unit, (130),
wherein the back reflection layer (160) includes a first back reflection layer (161) doped with n-type or p-type impurities
wherein the first back reflection layer (161) directly contacts the first intrinsic layer (132) of the first photoelectric conversion unit (130), the first back reflection layer (161) being formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H), and **characterized in that** the back reflection layer (160) further includes a second back reflection layer (162) positioned at a back suface of the first back reflection layer (161),
wherein the second back reflection layer (162) is formed of one of aluminum-doped zinc oxide (AZO) and boron-doped zinc oxide (BZO).

2. The thin film solar cell of claim 1, wherein the first back reflection layer (161) is formed of a material that has an absorption coefficient equal to or less than about 400 cm⁻¹ with respect to a solar light component having a wavelength equal to or greater than about 700 nm.

3. The thin film solar cell of claim 1, wherein the first back reflection layer (161) is formed of a material that has a refractive index of about 1.5 to 2.5 at a wavelength of about 800 nm.

4. The thin film solar cell of claim 1, wherein the second back reflection layer (162) is formed of a material that has an absorption coefficient equal to or greater than about 400 cm⁻¹ with respect to a solar light component having a wavelength equal to or greater than about 700 nm.

5. The thin film solar cell of claim 4, wherein an electrical conductivity of the second back reflection layer (162) is greater than an electrical conductivity of the first back reflection layer (161).

6. The thin film solar cell of claim 1, further comprising a second photoelectric conversion unit (140) between the first photoelectric conversion unit (130) and the substrate and a middle reflection layer (180) between the first photoelectric conversion unit (130) and the second photoelectric conversion unit (140), wherein the second photoelectric conversion unit (140) includes a second intrinsic layer (142).

7. The thin film solar cell of claim 6, wherein the middle reflection layer (180) includes a first middle reflection layer (181) directly contacting the first intrinsic layer (132), and
the first middle reflection layer (181) is formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H).

8. The thin film solar cell of claim 7, wherein the middle reflection layer (180) further includes a second middle reflection layer (182) directly contacting both the first middle reflection layer (181) and the second intrinsic layer (142), and
the second middle reflection layer (182) is formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H).

9. The thin film solar cell of claim 6, wherein the first photoelectric conversion unit (130) further includes a p-type doped layer (131), and the middle reflection layer (180) includes a first middle reflection layer (181) directly contacting the p-type doped layer (131) of the first photoelectric conversion unit (130), and
the first middle reflection layer (181) is formed of one of aluminum-doped zinc oxide (AZO) and boron-doped zinc oxide (BZO).

10. The thin film solar cell of claim 9, wherein the middle reflection layer (180) further includes a second middle reflection layer (182) directly contacting both the first middle reflection layer (181) and the second intrinsic layer (142), and
the second middle reflection layer (182) is formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H).

11. The thin film solar cell of claim 6, further comprising a third photoelectric conversion unit (150) between the second photoelectric conversion unit (140) and the substrate (110) and at least one middle reflection layer (180) between the first (130) and third (150) photoelectric conversion units.

12. The thin film solar cell of claim 11, wherein the at least one middle reflection layer (180) indudes a first middle reflection layer (181) that is formed of one of aluminum-doped zinc oxide (AZO) and boron-doped zinc oxide (BZO), or that is formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H).

13. The thin film solar cell of claim 12, wherein the at least one middle reflection layer (180) further includes a second middle reflection layer (182) that is formed of one of n-type or p-type hydrogenated microcrystalline silicon oxide (µc-SiOx:H), n-type or p-type hydrogenated microcrystalline silicon nitride (µc-SiNx:H), and n-type or p-type hydrogenated microcrystalline silicon oxynitride (µc-SiOxNy:H).

## Patentansprüche

1. Dünnfilm-Solarzelle mit:
einem Substrat (110);
einer ersten fotoelektrischen Umwandlungseinheit (130), die auf dem Substrat (110) angeordnet ist, wobei die erste fotoelektrische Umwandlungseinheit (130) eine erste intrinsische Schicht (132) zur Lichtabsorption aufweist; und
einer hinteren Rückstrahlungsschicht (160), die dazu ausgebildet ist, durch die erste fotoelektrische Umwandlungseinheit (130) weitergeleitetes Licht zurück zu der ersten fotoelektrischen Umwandlungseinheit (130) zu reflektieren,
wobei die hintere Rückstrahlungsschicht (160) eine erste hintere Rückstrahlungsschicht (161) aufweist, die mit Fremdstoffen vom N-Typ oder vom P-Typ dotiert ist,
wobei die erste hintere Rückstrahlungsschicht (161) in direktem Kontakt mit der ersten intrinsischen Schicht (132) der ersten fotoelektrischen Umwandlungseinheit (130) steht und die erste hintere Rückstrahlungsschicht (161) aus hydriertem mikrokristallinen Siliciumoxid (µc-SiOx:H) vom N-Typ oder vom P-Typ, oder aus hydriertem mikrokristallinen Siliciumnitrid (µc-SiNx:H) vom N-Typ oder vom P-Typ, oder aus hydriertem mikrokristallinen Siliciumoxinitrid (µc-SiOxNy:H) vom N-Typ oder vom P-Typ gebildet ist, und
**dadurch gekennzeichnet, dass** die hintere Rückstrahlungsschicht (160) des Weiteren eine zweite hintere Rückstrahlungsschicht (162) aufweist, die auf einer Rückfläche der ersten hinteren Rückstrahlungsschicht (161) angeordnet ist,
wobei die zweite hintere Rückstrahlungsschicht (162) entweder aus mit Aluminium dotiertem Zinkoxid (AZO) oder aus mit Bor dotiertem Zinkoxid (BZO) gebildet ist.

2. Dünnfilm-Solarzelle nach Anspruch 1, wobei die erste hintere Rückstrahlungsschicht (161) aus einem Material gebildet ist, das einen Absorptionskoeffizienten aufweist, der kleiner oder gleich etwa 400 cm⁻¹ ist bezüglich einer Sonnenlichtkomponente mit einer Wellenlänge größer oder gleich etwa 700 nm.

3. Dünnfilm-Solarzelle nach Anspruch 1, wobei die erste hintere Rückstrahlungsschicht (161) aus einem Material gebildet ist, das bei einer Wellenlänge von etwa 800 nm einen Brechungsindex von etwa 1,5 bis 2,5 aufweist.

4. Dünnfilm-Solarzelle nach Anspruch 1, wobei die zweite hintere Rückstrahlungsschicht (162) aus einem Material gebildet ist, das einen Absorptionskoeffizienten aufweist, der größer oder gleich etwa 400 cm⁻¹ ist bezüglich einer Sonnenlichtkomponente mit einer Wellenlänge größer oder gleich etwa 700 nm.

5. Dünnfilm-Solarzelle nach Anspruch 4, wobei eine elektrische Leitfähigkeit der zweiten hinteren Rückstrahlungsschicht (162) größer ist als eine elektrische Leitfähigkeit der ersten hinteren Rückstrahlungsschicht (161).

6. Dünnfilm-Solarzelle nach Anspruch 1, die des Weiteren eine zweite fotoelektrische Umwandlungseinheit (140) zwischen der ersten fotoelektrischen Umwandlungseinheit (130) und dem Substrat (110) sowie eine mittlere Rückstrahlungsschicht (180) zwischen der ersten fotoelektrischen Umwandlungseinheit (130) und der zweiten fotoelektrischen Umwandlungseinheit (140) aufweist, wobei die zweite fotoelektrische Umwandlungseinheit (140) eine zweite intrinsische Schicht (142) aufweist.

7. Dünnfilm-Solarzelle nach Anspruch 6, wobei die mittlere Rückstrahlungsschicht (180) eine erste mittlere Rückstrahlungsschicht (181) aufweist, die in direktem Kontakt mit der ersten intrinsischen Schicht (132) steht, und
die erste mittlere Rückstrahlungsschicht (181) aus hydriertem mikrokristallinen Siliciumoxid (µc-SiOx:H) vom N-Typ oder vom P-Typ, oder aus hydriertem mikrokristallinen Siliciumnitrid (µc-SiNx:H) vom N-Typ oder vom P-Typ, oder aus hydriertem mikrokristallinen Siliciumoxinitrid (µc-SiOxNy:H) vom N-Typ oder vom P-Typ gebildet ist.

8. Dünnfilm-Solarzelle nach Anspruch 7, wobei die mittlere Rückstrahlungsschicht (180) des Weiteren eine zweite mittlere Rückstrahlungsschicht (182) aufweist, die in direktem Kontakt sowohl mit der ersten mittleren Rückstrahlungsschicht (181) als auch mit der zweiten intrinsischen Schicht (142) steht, und
die zweite mittlere Rückstrahlungsschicht (182) aus hydriertem mikrokristallinen Siliciumoxid (µc-SiOx:H) vom N-Typ oder vom P-Typ, oder aus hydriertem mikrokristallinen Siliciumnitrid (µc-SiNx:H) vom N-Typ oder vom P-Typ, oder aus hydriertem mikrokristallinen Siliciumoxinitrid (µc-SiOxNy:H) vom N-Typ oder vom P-Typ gebildet ist.

9. Dünnfilm-Solarzelle nach Anspruch 6, wobei die erste fotoelektrische Umwandlungseinheit (130) des Weiteren eine dotierte Schicht vom P-Typ (131) aufweist und die mittlere Rückstrahlungsschicht (180) eine erste mittlere Rückstrahlungsschicht (181) aufweist, die in direktem Kontakt mit der dotierten Schicht vom P-Typ (131) der ersten fotoelektrischen Umwandlungseinheit (130) steht, und
die erste mittlere Rückstrahlungsschicht (181) entweder aus mit Aluminium dotiertem Zinkoxid (AZO) oder aus mit Bor dotiertem Zinkoxid (BZO) gebildet ist.

10. Dünnfilm-Solarzelle nach Anspruch 9, wobei die mittlere Rückstrahlungsschicht (180) des Weiteren eine zweite mittlere Rückstrahlungsschicht (182) aufweist, die in direktem Kontakt sowohl mit der ersten mittleren Rückstrahlungsschicht (181) als auch mit der zweiten intrinsischen Schicht (142) steht, und
die zweite mittlere Rückstrahlungsschicht (182) aus hydriertem mikrokristallinen Siliciumoxid (µc-SiOx:H) vom N-Typ oder vom P-Typ, oder aus hydriertem mikrokristallinen Siliciumnitrid (µc-SiNx:H) vom N-Typ oder vom P-Typ, oder aus hydriertem mikrokristallinen Siliciumoxinitrid (µc-SiOxNy:H) vom N-Typ oder vom P-Typ gebildet ist.

11. Dünnfilm-Solarzelle nach Anspruch 6, die des Weiteren eine dritte fotoelektrische Umwandlungseinheit (150) zwischen der zweiten fotoelektrischen Umwandlungseinheit (140) und dem Substrat (110) sowie mindestens eine mittlere Rückstrahlungsschicht (180) zwischen der ersten (130) und der dritten (150) fotoelektrischen Umwandlungseinheit aufweist.

12. Dünnfilm-Solarzelle nach Anspruch 11, wobei die mindestens eine mittlere Rückstrahlungsschicht (180) eine erste mittlere Rückstrahlungsschicht (181) aufweist, die entweder aus mit Aluminium dotiertem Zinkoxid (AZO) oder aus mit Bor dotiertem Zinkoxid (BZO) gebildet ist oder die aus hydriertem mikrokristallinen Siliciumoxid (µc-SiOx:H) vom N-Typ oder vom P-Typ, oder aus hydriertem mikrokristallinen Siliciumnitrid (µc-SiNx:H) vom N-Typ oder vom P-Typ, oder aus hydriertem mikrokristallinen Siliciumoxinitrid (µc-SiOxNy:H) vom N-Typ oder vom P-Typ gebildet ist.

13. Dünnfilm-Solarzelle nach Anspruch 12, wobei die mindestens eine mittlere Rückstrahlungsschicht (180) des Weiteren eine zweite mittlere Rückstrahlungsschicht (182) aufweist, die aus hydriertem mikrokristallinen Siliciumoxid (µc-SiOx:H) vom N-Typ oder vom P-Typ, oder aus hydriertem mikrokristallinen Siliciumnitrid (µc-SiNx:H) vom N-Typ oder vom P-Typ, oder aus hydriertem mikrokristallinen Siliciumoxinitrid (µc-SiOxNy:H) vom N-Typ oder vom P-Typ gebildet ist.

## Revendications

1. Cellule solaire à film mince comprenant :
un substrat (110) ;
une première unité de conversion photoélectrique (130) positionnée sur le substrat (110), la première unité de conversion photoélectrique (130) incluant une première couche intrinsèque (132) pour une absorption de lumière ; et
une couche de rétroréflexion (160) configurée pour rétroréfléchir une lumière transmise par la première unité de conversion photoélectrique (130) jusqu'à la première unité de conversion photoélectrique (130),
dans laquelle la couche de rétroréflexion (160) inclut une première couche de rétroréflexion (161) dopée avec des impuretés de type n ou de type p,
dans laquelle la première couche de rétroréflexion (161) est directement en contact avec la première couche intrinsèque (132) de la première unité de conversion photoélectrique (130), la première couche de rétroréflexion (161) étant formée d'un parmi un oxyde de silicium microcristallin hydrogéné de type n ou de type p (µc-SiOx:H), un nitrure de silicium microcristallin hydrogéné de type n ou de type p (µc-SiNx:H), et un oxynitrure de silicium microcristallin hydrogéné de type n ou de type p (µc-SiOxNy:H), et
**caractérisée en ce que** la couche de rétroréflexion (160) inclut en outre une deuxième couche de rétroréflexion (162) positionnée au niveau d'une surface de dos de la première couche de rétroréflexion (161),
dans laquelle la deuxième couche de rétroréflexion (162) est formée d'un parmi un oxyde de zinc dopé à l'aluminium (AZO) et un oxyde de zinc dopé au bore (BZO).

2. Cellule solaire à film mince selon la revendication 1, dans laquelle la première couche de rétroréflexion (161) est formée d'un matériau qui a un coefficient d'absorption égal ou inférieur à environ 400 cm⁻¹ par rapport à une composante de lumière solaire ayant une longueur d'onde égale ou supérieure à environ 700 nm.

3. Cellule solaire à film mince selon la revendication 1, dans laquelle la première couche de rétroréflexion (161) est formée d'un matériau qui a un indice de réfraction d'environ 1,5 à 2,5 à une longueur d'onde d'environ 800 nm.

4. Cellule solaire à film mince selon la revendication 1, dans laquelle la deuxième couche de rétroréflexion (162) est formée d'un matériau qui a un coefficient d'absorption égal ou supérieur à environ 400 cm⁻¹ par rapport à une composante de lumière solaire ayant une longueur d'onde égale ou supérieure à environ 700 nm.

5. Cellule solaire à film mince selon la revendication 4, dans laquelle une conductivité électrique de la deuxième couche de rétroréflexion (162) est supérieure à une conductivité électrique de la première couche de rétroréflexion (161).

6. Cellule solaire à film mince selon la revendication 1, comprenant en outre une deuxième unité de conversion photoélectrique (140) entre la première unité de conversion photoélectrique (130) et le substrat (110) et un couche de réflexion médiane (180) entre la première unité de conversion photoélectrique (130) et la deuxième unité de conversion photoélectrique (140), dans laquelle la deuxième unité de conversion photoélectrique (140) inclut une deuxième couche intrinsèque (142).

7. Cellule solaire à film mince selon la revendication 6, dans laquelle la couche de réflexion médiane (180) inclut une première couche de réflexion médiane (181) directement en contact avec la première couche intrinsèque (132), et
la première couche de réflexion médiane (181) est formée d'un parmi un oxyde de silicium microcristallin hydrogéné de type n ou de type p (µc-SiOx:H), un nitrure de silicium microcristallin hydrogéné de type n ou de type p (µc-SiNx:H), et un oxynitrure de silicium microcristallin hydrogéné de type n ou de type p (µc-siOxNy:H).

8. Cellule solaire à film mince selon la revendication 7, dans laquelle la couche de réflexion médiane (180) inclut en outre une deuxième couche de réflexion médiane (182) directement en contact avec à la fois la première couche de réflexion médiane (181) et la deuxième couche intrinsèque (142), et
la deuxième couche de réflexion médiane (182) est formée d'un parmi un oxyde de silicium microcristallin hydrogéné de type n ou de type p (µc-SiOx:H), un nitrure de silicium microcristallin hydrogéné de type n ou de type p (µc-SiNx:H), et un oxynitrure de silicium microcristallin hydrogéné de type n ou de type p (µc-SiOxNy:H).

9. Cellule solaire à film mince selon la revendication 6, dans laquelle la première unité de conversion photoélectrique (130) inclut en outre une couche dopée de type p (131), et la couche de réflexion médiane (180) inclut une première couche de réflexion médiane (181) directement en contact avec la couche dopée de type p (131) de la première unité de conversion photoélectrique (130), et
la première couche de réflexion médiane (181) est formée d'un parmi un oxyde de zinc dopé à l'aluminium (AZO) et un oxyde de zinc dopé au bore (BZO).

10. Cellule solaire à film mince selon la revendication 9, dans laquelle la couche de réflexion médiane (180) inclut en outre une deuxième couche de réflexion médiane (182) directement en contact avec à la fois la première couche de réflexion médiane (181) et la deuxième couche intrinsèque (142), et
la deuxième couche de réflexion médiane (182) est formée d'un parmi un oxyde de silicium microcristallin hydrogéné de type n ou de type p (µc-SiOx:H), un nitrure de silicium microcristallin hydrogéné de type n ou de type p (µc-SiNx:H), et un oxynitrure de silicium microcristallin hydrogéné de type n ou de type p (µc-SiOxNy:H).

11. Cellule solaire à film mince selon la revendication 6, comprenant en outre une troisième unité de conversion photoélectrique (150) entre la deuxième unité de conversion photoélectrique (140) et le substrat (110) et au moins une couche de réflexion médiane (180) entre les première (130) et troisième (150) unités de conversion photoélectrique.

12. Cellule solaire à film mince selon la revendication 11, dans laquelle l'au moins une couche de réflexion médiane (180) inclut une première couche de réflexion médiane (181) qui est formée d'un parmi un oxyde de zinc dopé à l'aluminium (AZO) et un oxyde de zinc dopé au bore (BZO), ou qui est formée d'un parmi un oxyde de silicium microcristallin hydrogéné de type n ou de type p (µc-SiOx:H), un nitrure de silicium microcristallin hydrogéné de type n ou de type p (µc-SiNx:H), et un oxynitrure de silicium microcristallin hydrogéné de type n ou de type p (µc-SiOxNy:H).

13. Cellule solaire à film mince selon la revendication 12, dans laquelle l'au moins une couche de réflexion médiane (180) inclut en outre une deuxième couche de réflexion médiane (182) qui est formée d'un parmi un oxyde de silicium microcristallin hydrogéné de type n ou de type p (µc-SiOx:H), un nitrure de silicium microcristallin hydrogéné de type n ou de type p (µc-SiNx:H), et un oxynitrure de silicium microcristallin hydrogéné de type n ou de type p (µc-SiOxNy:H).
